# EUROPEAN PATENT APPLICATION

(11) **EP 3 147 941 A1**
(43) Date of publication of application: **29.03.2017**
(21) Application number: 15186443.6
(22) Date of filing: 23.09.2015
(51) Int. Cl.: H01L 23/473, H01L 21/48

(54) **SEMI-FINISHED PRODUCT AND METHOD FOR PRODUCING A POWER SEMICONDUCTOR MODULE**

(71) Applicant: ABB Technology AG, 8050 Zürich (CH)
(72) Inventor: Mohn, Fabian, 5408 Ennetbaden (CH); Traub, Felix, 4310 Rheinfelden (CH); Kearney, Daniel, 8004 Zürich (CH); Schuderer, Jürgen, 8047 Zürich (CH)
(74) Representative: ABB Patent Attorneys

(57) **Abstract**

The present invention relates to a semi-finished product (12) for producing a power semiconductor module (10), in particular for forming a half-bridge module, the semi-finished product (12) comprising a first cooler part (14) supporting at least one power semiconductor device (28, 30) and comprising a second cooler part (40) supporting at least one power semiconductor device (44, 46), wherein the first cooler part (14) is not assembled to the second cooler part (40). Such a semi-finished product (12) allows an improved manufacturabilty.

## Description

### Technical Field

The Invention relates to a semi-finished product for producing a power semiconductor module. Further, the invention relates to a method for forming a power semiconductor module showing an improved producibility.

### Background Art

Power semiconductor devices, such as IGBTs or Power MOSFETs, are used in various power electronics applications to switch or rectify large electric currents. An important and fast growing application are converter systems for electric or hybrid electric vehicles (EV/HEV). In this application, power density and high-temperature operation are crucial requirements. The use of alternative wide-bandgap semiconductor devices, such as silicon carbide, promises further improvements in this respect. However, to fully utilize the advantageous properties of SiC power semiconductor devices, such as the possibility of operation at higher current densities, higher switching frequencies, and higher temperatures, new packaging concepts are required that enable more compact power semiconductor modules with lower stray impedances and enhanced cooling capability.

One possible solution to this challenge is to design double-side-cooled modules by sandwiching the power semiconductor chips between two direct bonded copper (DBC) substrates, but this requires a planar structure on both sides of the semiconductor chips that is not compatible with conventional wire bond interconnection of the chip top side. Another drawback of this solution is that such a DBC sandwich arrangement is typically clamped between two coolers using layers of thermal grease, which indicates a significant mounting overhead and limits the cooling benefits compared to advanced one-side power module cooling solutions, such as integrated pin-fin baseplates. Furthermore, no significant reduction of the footprint of the power module can be achieved, in contrast to a 3D arrangement of power semiconductor chips.

Documents DE 44 21 319 A1 and EP 0 688 053 disclose that the power semiconductor chips are arranged on two opposite sides of a fluid cooler and are contacted by metallic sheets that are arranged essentially parallel to the cooler. More specifically, the power semiconductor devices are preferably arranged on insulating ceramic substrates and high-side switches and diodes are arranged on one side of the cooler and low-side switches are arranged on the opposite side, to form a half bridge power module configuration. According to this document, the semiconductor chips are first assembled on substrates, the substrates are then bonded to the two sides of the cooler, and finally, conducting terminal sheets are attached to the substrates.

Document US 2011/0012252 A1 describes a power semiconductor module, wherein metal plates each having a first through hole are provided, with an anodic oxidation layer formed on a surface of the metal plates and an interior of the first through hole. A cooling member, such as comprising a heat pipe in which a refrigerant may flow, has a second through hole at a position corresponding to the first through hole, and the metal plates are attached to both sides of the cooling member. A circuit layer is formed on the anodic oxidation layer and performs an interlayer connection through a via formed in the first and second through holes. A power device is connected to the circuit layer. A resin encapsulant encloses the circuit layer and the power device. A housing is installed to each of the metal plates to form a sealing space for the resin encapsulant.

Document WO 2015/086184 A1 describes a semiconductor stack arrangement. The semiconductor stack arrangement comprises a first semiconductor chip with a planar terminal mounted to a side of the first semiconductor chip; a second semiconductor chip with a planar terminal mounted to a side of the second semiconductor chip, which may be opposite to the side of the first semiconductor chip; and an interposer arranged between the first semiconductor chip and the second semiconductor chip for electrically connecting the planar terminal of the first semiconductor chip and the planar terminal of the second semiconductor chip. Therein, a first side of the interposer is in thermal contact with the planar terminal of the first semiconductor chip and a second side of the interposer is in thermal contact with the planar terminal of the second semiconductor chip. The interposer comprises at least one channel or a plurality of channels adapted for cooling the first semiconductor chip and the second semiconductor chip. Accordingly, the interposer may be adapted for cooling the semiconductor stack arrangement.

Tang et al. describe in "Hybrid substrate - A future material for power semiconductor devices", PCIM Europe 2014, 20-22 May 2014, Nürnberg, Germany, pages 169-173, a hybrid substrate comprising of copper ceramic and aluminum that is described to have improved properties.

Mermet-Guyennet et al., "3D Integration of Power Semiconductor Devices based on Surface Bump Technology", 5th International Conference on Integrated Power Systems (CIPS), 2008, describes stacking of semiconductor devices in a half-bridge module based on the power bump technology, which consist essentially in the replacement of bond-wire interconnections between device surface and substrate with conductive solid elements directly connected to an upper substrate. Within this publication, double-sided cooling of power switches is described.

Such an approach of double-sided cooling of power devices is as well disclosed in Johnson et al., "Compact Double-Side Liquid-Impingement-Cooled Integrated Power Electronic Module", Proceedings of the 19th International Symposium on Power Semiconductor Devices & ICs, 2007.

There is, however, still room for improvements especially regarding producing power semiconductor modules.

### Summary of invention

It is therefore an object of the present invention to at least partly prevent at least one of the disadvantages known in the art.

In particular, it is an object of the present invention to provide a method for forming a power semiconductor module which is easy and cost-saving to perform.

These objects are at least partly achieved by a semi-finished product according to claim 1. These objects are further at least partly achieved by a method according to claim 12 and by a power semiconductor module according to claim 15. Preferred embodiments of the present invention are defined in the dependent claims.

The invention relates to a semi-finished product for producing a power semiconductor module, in particular for forming a half-bridge module, the semi-finished product comprising a first cooler part supporting at least one power semiconductor device and comprising a second cooler part supporting at least one power semiconductor device, wherein the first cooler part is not assembled to the second cooler part.

Such a semi-finished product provides an improved producibility especially when forming a half-bridge module.

A semi-finished product according to the present invention is particularly a product which may be used for producing a power semiconductor module. However, a semi-finished product requires at least one further production step, in particular a plurality of further production steps, for forming the power semiconductor module.

The semi-finished product is particularly suited for producing a half-bridge module. As such, it may particularly be designed for forming a power semiconductor module which comprises a central cooling unit which cooling unit is adapted for supporting respective power semiconductor devices. In particular, it may be provided that at least two power semiconductor devices are positioned at opposite surfaces of the cooler, or cooling unit, respectively.

With regard to the half-bridge configuration, an arrangement may thus be provided with the high-side and low-side switches on opposite sides of the cooler. This is the simplest way to arrange a half-bridge topology, because only two power terminal connections are needed to connect to each side of the cooler. In terms of stray inductance, it may however be more preferable to have separate parallel half-bridge arrangements on each side of the cooler, at the expense of having additional terminal connections. Such an arrangement is supposed to be also included in the sense of this invention disclosure.

The semi-finished product as described comprises a first cooler part supporting at least one power semiconductor device and comprises a second cooler part supporting at least one power semiconductor device. Thus, the semi-finished product comprises at least two cooler parts.

It may in an embodiment be provided that each cooler part comprises at least one substrate for positioning at least one power semiconductor module to said substrate. Thus, each of the cooler parts comprises a substrate for supporting at least one power semiconductor device. In other words, the first cooler part may have a first substrate for supporting at least one power semiconductor device the second cooler part may have a second substrate for supporting at least one power semiconductor device, wherein at least one power semiconductor device is attached to the first substrate and wherein at least one power semiconductor device is attached to the second substrate.

These substrates are preferably positioned such, that after assembling the cooling elements and thus after forming the cooling element, these substrates are positioned at opposite surfaces of the cooling element.

Alternatively, it may be provided that the respective one or more power semiconductor devices are positioned directly on the cooler part as it is described in detail down below.

The respective cooler parts may be designed such, that by attaching the cooler parts to each other, they may contribute to forming a cooler. These cooler parts may thus form the whole cooler, or additionally to these cooler parts, further parts may be provided which are part of the cooler.

According to this, at least one step which is missing for producing the power semiconductor module out of the semi-finished product is the step of assembling the cooler or the cooler parts, respectively.

The cooler elements may be formed from either an electrically insulating or from an electrically conductive material. In dependence of the material of the cooler elements, the substrate may optionally comprise an electrically insulating layer and metallizations located thereon in order to position and to electrically interconnect the power semiconductor devices.

Especially in case the cooler is formed from an electrically conductive material, in order to insulate the power semiconductor devices from the cooler and to provide means for distributing the different power and auxiliary signals, insulating substrates such as for example DBC substrates may be attached to the cooler parts. The substrates such as the DBC substrates can be attached by means of soldering, sintering, and the like.

Alternatively, the substrate may be an insulated metal substrate or a hybrid substrate which comprises, for example on a cooler part being formed from aluminum, a layer of ceramic which may be attached to the cooler part by an adhesive and a layer of copper, such as a structured copper metallization, on the ceramic layer. Such a substrate has improved properties with regard to thermal management as well as lifetime and is for example described in Tang et al., "Hybrid substrate - A future material for power semiconductor devices", PCIM Europe 2014, 20-22 May 2014, Nürnberg, Germany, pages 169-173.

It may further be provided that the one or more power semiconductor devices are directly attached particularly to an electrically insulating cooler part.

However, the specific arrangement of the substrate may be chosen in dependence of the arrangement of the cooler, i.e. if the cooler is formed from an electrically conductive or insulating material, like it is obvious for the person skilled in the art. The substrate may for example be formed like it is known for the person skilled in the art for substrates for power semiconductor modules.

Further, at least one power semiconductor device is supported from each cooler part and is thus is attached to the respective cooler part, for example to the respective substrate. In other words, at least one power semiconductor device is attached to the first cooler part and at least one power semiconductor device is attached to the second cooler part. The semi-finished product is particularly designed such, that power semiconductor devices, or semiconductor chips, respectively, are arranged on both sides of a cooler integrated in the module after assembly of the cooler.

With regard to the power semiconductor devices, generally conventional devices, or chips may be provided. With decreasing switching times of modern power semiconductors, especially devices being based on novel semiconductor materials like SiC and GaN may be preferred. Further, at least one power semiconductor device is provided at each cooler part, which means that one or more than one devices may each be provided, wherein the specific number of devices provided at each cooler part may be the same or may vary with regard to further cooler part.

Like stated above, regarding the semi-finished product as described it is provided that the first cooler part is not assembled to the second cooler part or, in other words, the first cooler part is not attached to and thus preferably not mechanically connected to the second cooler part. Therefore, the cooler is not formed but the cooler parts are located independently from each other. It is, however, not excluded from the present invention that both cooler parts are attached to a common support for manufacturing reasons. However, in the latter case it is preferred that the cooler parts are removed from said support in order to attach the cooler parts to each other and thus to assemble the cooler, or the cooler parts, respectively.

Such a measure provides significant advantages over solutions of the prior art.

In fact, due to the feature that the first cooler part is not assembled to the second cooler part, the production process of the power semiconductor module may significantly be enhanced. In detail it is provided that the cooler is assembled from at least two separate parts, wherein the assembly of the cooler may be realized after the die attach and preferably after the formation of the respective electrical interconnections. This feature may help simplifying the assembly of the chip/cooler arrangement significantly compared to solutions described in the prior art. In fact, known peripheries for producing power modules may be used which, however, may significantly be simplified due to the fact that the die attach may be realized from one direction, only, i.e. especially only from the top. This as well simplifies the production process significantly.

The semi-finished product as described further enables simplified electrical testing on the single-substrate level as the power semiconductor devices being attached to each cooler part may be tested alone. This allows wasting less parts in case some of the assembled parts do not work properly, as not the whole module but only parts thereof may be exchanged in case an error occurs. This leads to improved yields by possibility of testing before the assembly of the cooler parts.

Apart from the above, the proposed solution features a terminal design that with regard to technical characteristics corresponds to standard power module terminal solutions. In fact, very high power densities and favourable electrical characteristics may be provided in a design that is manufacturable using essentially only well-established assembly technologies.

Thus, the power semiconductor devices and their electrical interconnections such as terminals, wire bonds, etc. are assembled on two separate cooler parts, which are later joined to create a cooler structure with devices on both sides.

Further, a requirement for flipping the chips, or the transistors, respectively, is not given, even though under circumstances, flipping the chips may be advantageous in a power semiconductor module as described here. Therefore, the manufacturing process can further be kept simple.

With regard to conventional 2D packages, the following advantages may additionally appear.

Firstly, improved cooling of the power semiconductor devices may be realized as less interfaces and layers contributing to the total thermal resistance are provided. This is true especially compared to modules mounted on a heat sink. Therefore more compact designs and higher power densities may be enabled. Further, such an integrated cooling approach provides a separation of cooling path and external high-voltage insulation and may enable new integration concepts.

With regard to the position of the power semiconductor devices, the shown two-side arrangement of the chips on the cooler provides footprint reduction exemplarily by about a factor of two.

Apart from the above, low commutation loop stray inductance may be reached. First simulations of a simple module geometry based on the described solution yielded a stray inductance of 4.7 nH for a half-bridge module with 6 switches and 3 diodes for high- and low-side, respectively. This can be compared to the value of 6.0 nH obtained for a 2D arrangement with identical number of devices and similar substrate and terminal design.

Further, no capacitive coupling path through external heat sink is present, which in turn avoids or reduces problems with regard to electromagnetic interferences (EMI).

Furthermore, compared to prior art solutions with chip arrangements on both sides of a cooler, a semi-finished product as described may lead to the following advantages.

The provision of separate cooler parts each optionally comprising a substrate for supporting at least one power semiconductor device enables the usage of standard processes for die bonding, wire bonding, and terminal attachment. In fact, there is no need for bonding on opposite sides of the cooler, which simplifies the manufacturing processes.

Conventional terminal arrangement on the top side of the module is further advantageous in terms of module integration and it may be easier to produce with cooler made from separate layers.

Coolers made from two or more layers further will be easier/cheaper to manufacture.

According to an embodiment, at least one diode and at least on switch are attached to the first cooler part and at least one diode and at least one switch are attached the second cooler part. According to this embodiment, the semi-finished product may serve for producing a power semiconductor module which is designed as a half-bridge configuration. It comprises particularly at least two power semiconductor devices. i.e. the at least one switch and the at least one switch. In fact, it may comprise exactly two or more than two power semiconductor devices like described above.

Even though the following description is performed for only two power semiconductor devices, it is as well valid for more than two power semiconductor devices or further electronic devices. For example, it may be provided that the power semiconductor module forms a dc-dc, ac-dc, dc-ac, and ac-ac power converter, in which cases additionally to one or more transistors, or switches, respectively and one or more diodes, one or more inductors and one or more capacitors may be provided.

The power semiconductor switch advantageously is a switch for power applications and may comprise, inter alia, a MOSFET, an IGBT, or the like, as it is generally known in the art. The power semiconductor diode is as well generally known in the art. Such a power semiconductor module may for example form a half-bridge configuration comprising both a p-cell and an n-cell.

According to this embodiment, especially an improved 3D packaging geometry for a compact half-bridge power semiconductor module is provided.

According to a further embodiment, the first and the second cooler parts may be formed from an electrically conductive material, such as from a metal. For example, the respective cooler parts may consist of an electrically conductive material, such as a metal. As an example, aluminum or copper may be used for the metal.

According to this embodiment, the advantage of an especially cost-saving producibility may be reached. Further, advantages with regard to electrical behavior may be reached as lower inductance may be achieved and further, no partial discharge in the cooling liquid is to be expected.

In case the respective cooler parts are formed from an electrically conductive material and in order to form the substrate, it may be provided that the first substrate comprises a substrate metallization being formed on an electrically insulating layer, the electrically insulating layer being located particularly directly on the first cooler part and/or that the second substrate comprises a substrate metallization being formed on an electrically insulating layer, the electrically insulating layer being located particularly directly on the second cooler part. The insulating layer may be formed from a ceramic material, such as alumina (Al₂O₃), aluminium nitride (AIN) or silicon nitride (Si₃N₄) and the metallization which may be formed by patterned metal traces, may be formed by using copper or aluminum. This embodiment allows an especially easy formation of the substrate, wherein the substrate may be formed by using conventional materials and techniques.

As it is generally known as such, the substrate metallization serves for carrying and electrically interconnecting the power semiconductor device and thus to provide electrical interconnections between the power semiconductor devices and terminals, for example.

The substrate may be formed by a main layer being formed from above-defined ceramic substrate material with metallizations on both sides, one being provided to attach at least one chip, the other to connect the substrate to the respective cooler part. The substrate main layer may be realized to provide mechanical substrate, whereas the upper metallization may provide electrical contact to one or multiple semiconductor devices and the lower metallization may provide contact to said cooler part.

According to a further embodiment, the first and the second cooler parts are formed from an electrically insulating material, such as a ceramic material. In detail, the respective cooler parts may be formed from or may comprise alumina (Al₂O₃), aluminium nitride (AlN) or silicon nitride (Si₃N₄), or further materials as generally known in the art.

The advantage of an electrically insulating cooler part may be found in that no common substrate is required. Instead, it may be provided that a substrate metallization is formed particularly directly on the first cooler part and/or in that a substrate metallization is formed particularly directly on the second cooler part. Such an embodiment is for example the one being published under its name 3i Power from the firm Ceramtec. According to this embodiment, no substrate having a ceramic main layer as known in the art needs to be generated, which allows an especially easy and cost-saving manufacturability, as essentially only a particularly structured metallization has to be applied to the cooler elements, which, however, is no substrate in the common sense.

The metallization which may be formed on the ceramic material may exemplarily comprise a copper metallization or a metallization from a further metal.

Next to the above-defined example, a metallic support for carrying the power semiconductor device can also be realized as a structured metallic plate, such as a copper plate, for example, which may be provided on an electrically insulating layer or on an electrically insulating cooler part.

According to a further embodiment, a third cooler part is provided for positioning the third cooler part between the first cooler part and the second cooler part.

According to this embodiment, the cooler parts supporting the power semiconductor devices do not need to be adapted to each other, but in contrast thereto, the third cooler part may be used as an adapter for attaching the first cooler part to the second cooler part. With this regard, an especially cost-saving production of the first and second cooler parts may be realized. Apart from that, a very efficient adaptability may be realized, as the first and the second cooler parts may be formed according to standard procedures and the third cooler part may be adapted, for example with regard to cooling power etc. to the desired application. Therefore, in order to adapt the cooler, only the third part has to be exchanged which allows a simplification of the respective adaption.

The first, second and third cooler parts may be designed such, that the third cooler part is clamped between the first and the second cooler part, or that each part is mechanically secured to the adjacent cooler part.

With regard to the third cooler part, the latter may be formed from the same material compared to the first and the second cooler part, or it may be formed from a different material. In order to electrically insulate the first cooler part from the second cooler part and/or to reduce the cost of the cooling structure, it may be advantageous that the third cooler part is formed from an electrically insulating material. For example, the third cooler part may be formed from plastic, such as an injection-molded plastic part. Such parts may be cheaply manufactured and may be effective insulators.

Therefore, according to this embodiment, a high adaptability may be combined with a cost-saving manufacturability.

According to a further embodiment, at least one of the first cooler part and the second cooler part and the third cooler part comprise at least a part of a cooling structure. With this regard, it may be advantageous that at least one of the cooler parts comprise premanufactured structures such as channels, recesses, fins, etc., which may serve for the cooler to work as a liquid cooler or as a 2-phase cooler. Thus the premanufactured structures may comprise channels or may be designed for forming channel after assembling the cooler parts, wherein the channels my serve for carrying a cooling liquid, once the respective cooler parts are assembled together.

With regard to the cooling structure it may be provided that the first cooling part comprises a first part of the cooling structure and the second cooler part comprises a second part of a cooling structure, wherein the first and the second part of the cooling structure are designed such, that by assembling the first cooler part to the second cooler part, at least one channel of the cooling structure is formed. With this regard, the respective cooling structures may comprise recesses, for example, which are formed such, that by assembling the cooler parts, the recesses are located adjacent to each other, thereby forming one or more channels for carrying a cooling liquid. For example according to this embodiment, respective sealings may be provided and may be positioned between the cooler parts when assembling the cooler parts in order to seal the cooling structure. A sealing may be formed by a gasket ring, for example.

According to this embodiment, the cooler may be produced in a very simple manner as the cooling structures may advantageously be formed by simple assembly of the respective cooler parts.

It may further be provided that the third cooling part comprises a cooling structure, wherein the cooling structure is embedded in the third cooler part or that the third cooler part comprises a part of the cooling structure and the first cooler part and the second cooler part and the third cooler part are designed such, that by assembling the first cooler part and the second cooler part and the third cooler part, the cooling structure is formed.

According to this embodiment, especially the first and the second cooler parts may be formed in a very cost-saving manner as these cooler parts may be free of any cooling structures which allows a simplified manufacturability. Regarding to the feature according which the cooling structure is embedded, it is clear that the structure is partly embedded as at least an inlet and an outlet for the cooling fluid has to be provided. Therefore, the cooling structure is advantageously embedded in a 2D-configuration.

With regard to the embodiment according to which the third cooler part made from an electrically insulative material is provided, the so-called shower power concept from the firm Danfoss may be realized. With this regard, an unstructured baseplate may be cooled with channels in an injection molded plastic part. This allows a further decrease in costs.

Regarding the embodiment according to which the cooling structure is embedded in the third cooler part, the first and the second cooler parts do not have to contribute to the cooling structure at all. Therefore, an especially simplified manufacturability of the first and second cooler parts may be realized. Further, sealings which otherwise may be provided between the respective cooler parts may be omitted, which may further help to reduce costs and to simplify the manufacturing process.

Referring to the embodiment according to which the first cooler part and the second cooler part and the third cooler part are designed such, that by assembling the first cooler part and the second cooler part to the third cooler part, the cooling structure is formed, again no defined structures have to be introduced into the first and the second cooler parts, even though this is not excluded from the present invention. The first and the second cooler parts just have to be designed such, that they may close structures, such as recesses, formed in the third cooler part, which, however, does not lead to strict requirements. Such a closure may for example be realized at least from the top and/or the bottom of the channels to be formed. For example, a flat surface may be sufficient to allow the first and the second cooler part to close the respective recesses, thereby forming channels for guiding cooling liquid. Again, a sealing may be provided between each of the first and the second cooler part on the one side and the third cooler part on the second side.

With regard to further technical features and advantages of the semi-finished product as described before, it is referred to the following description of the method, the power semiconductor module, the figures and the description of the figures.

The present invention further relates to a method for producing a power semiconductor module, in particular for forming a half-bridge module, comprising the steps of:
a) providing a first cooler part for supporting at least one power semiconductor device;
b) providing a second cooler part for supporting at least one power semiconductor device;
c) attaching at least one power semiconductor device to the first cooler part;
d) attaching at least one power semiconductor device to the second cooler part; and
e) assembling the first cooler part to the second cooler part after steps c) and d).

Such a method provides significant advantages with regard to costs as well as simplicity of the assembly of the power semiconductor module.

In detail, according to steps a) and b), respectively, the method comprises the steps of providing a first cooler part optionally having a first substrate for supporting at least one power semiconductor device and of providing a second cooler part optionally having a second substrate for supporting at least one power semiconductor device. With regard to the respective cooler parts, it is referred to the above description of the semi-finished product.

In case the substrate has to be attached to the respective cooler part, it may be provided that during the substrate bonding, the cooler parts may be temporarily fixed to a support structure, for example by screws, to prevent excessive warpage. According to this, the cooler parts are not assembled to each other.

With regard to process steps c) and d), respectively, the method provides attaching at least one power semiconductor device to the first cooler part such as to the first substrate and attaching at least one power semiconductor device to the second cooler part such as to the second substrate. It may be provided that one or more than one power semiconductor devices are attached to the first and second cooler part, such as substrate, respectively. With this regard, for example each a diode and a switch may be attached to each of the first and the second cooler part.

The power semiconductor devices, or chips, respectively, can be attached to the cooler before or after the substrate-to-cooler attach by soldering, sintering, and the like. The interconnection of the chip top sides can be achieved by conventional heavy wire bonding or alternatively by advanced planar top side interconnection approaches, for example. Finally, power and auxiliary terminals may be attached by means of welding, soldering, or sintering, for example. A comparable attachment processes can be used as for a conventional power module geometry without being limited by the specific cooler arrangement of the semi-finished product, due to the use of the two separate cooler parts. During the assembly, the entire cooler parts may still be fixed to the above-mentioned substrate structure.

After the attachment of all power semiconductor devices and particularly after attaching electric interconnections and terminals, etc., the method comprises the further step e) according to which the first cooler part and the second cooler part are assembled after steps c) and d). In other words, the two or more cooler parts are assembled together. This is preferably done by welding the two or more parts together or by the use of screws and rubber or plastic gaskets, which can provide a leak-tight sealing of the cooling liquid and thus of cooling structures like described above. Other options for connecting the cooler parts could be soldering or gluing with an adhesive, or the respective cooler parts may be clamped to each other.

After the cooler is assembled, the power and auxiliary terminals are preferably bent in such a shape that all terminal connections are on the module top side, as in a conventional power module geometry. To this end, the terminals may be prestructured to facility the bending, or already prebent terminals are attached to the substrates.

Like described above, it may be provided that the at least one power semiconductor device which is attached to the first cooler part is electrically connected to an electrically conductive structure being provided on the first cooler part before step e) and wherein the at least one power semiconductor device which is attached to the second cooler part is electrically connected to an electrically conductive structure being provided on the second cooler part before step e).

According to this embodiment, the power semiconductor devices are not only attached to the respective cooler parts, such as substrates, but the electrical interconnections are also formed prior to assembling the cooler. This embodiment further simplifies the manufacturing process as not only attaching the power semiconductor devices but additionally providing the electrical connections may be simplified like described above in detail.

According to a further embodiment, a third cooler part is positioned between the first cooler part and the second cooler part. With this regard, the power semiconductor module may be manufactured especially cost-saving and additionally, a high degree of adaptability may be realized.

According to a further embodiment, an electrical insulator is positioned between the first cooler part and the second cooler part. This embodiment allows forming the first and the second cooler part from a metal which in turn allows forming the respective substrates in a simple manner and according to which an electrical contact of the respective cooler parts carrying different power semiconductor devices is avoided. This allows the cooler parts to carry different electrical potentials.

According to a further embodiment, the method may comprise the further step of encapsulating the power semiconductor module in a housing, wherein the housing is filled with an encapsulation material.

In detail, the entire module arrangement as formed before is preferably encapsulated using an epoxy molding compound, for example by compression molding, transfer molding, or injection molding. The terminals that need to connect to both the upper and the lower side of the cooler can be simply arranged on top of each other and joined by the screws connecting the busbars. Alternatively, the terminals can be attached to each other before the epoxy molding by screwing, welding, or a kind of press connection. In this way, a module with small footprint, integrated cooling and a conventional terminal structure on the top side of the module is produced. Further, due to the encapsulation step, the power semiconductor module is especially stable and further resistant against outer influences, such as humidity.

With regard to further technical features and advantages of the method according to the invention, it is referred to the description of the semi-finished product and the power semiconductor module, as well as to the figures and the description of the figures.

The present invention further relates to a power semiconductor module, comprising a cooler and at least two power semiconductor devices, wherein the cooler comprises at least a first cooler part and a second cooler part, wherein the first cooler part and a second cooler part are mechanically connected to each other, and wherein the first cooler part supports at least one power semiconductor device and wherein the second cooler part supports at least one power semiconductor device.

In particular, the cooler parts and optionally the substrates may be arranged such, that the power semiconductor devices are provided at opposite sides of the cooler.

Such a power semiconductor device provides an improved manufacturability, as it is clear from the above description. With regard to the specific parts, it is referred to the above description.

With regard to further technical features and advantages of the power semiconductor module according to the invention, it is referred to the description of the semi-finished product and the method, as well as to the figures and the description of the figures.

### Brief description of drawings

Additional features, characteristics and advantages of the subject-matter of the invention are disclosed in the subclaims, the figures and the following description of the respective figures and examples, which -in an exemplary fashion- show embodiments and examples of a power semiconductor module and a semi-finished product for forming the latter according to the invention.

In the figures:
Figure 1 shows different parts for forming a semi-finished product for forming power semiconductor module;
Figure 2 shows an embodiment of a semi-finished product according to the invention;
Figure 3 shows an embodiment of a power semiconductor module according to the invention;
Figure 4 shows a further embodiment of a power semiconductor module according to the invention;
Figure 5 shows a further embodiment of a semi-finished product according to the invention; and
Figure 6 shows a further embodiment of a power semiconductor module according to the invention.

### Description of embodiments

In the figures, the method according to the present invention for producing a power semiconductor module 10 is schematically shown. The same or comparable elements are thereby described with the same numerals.

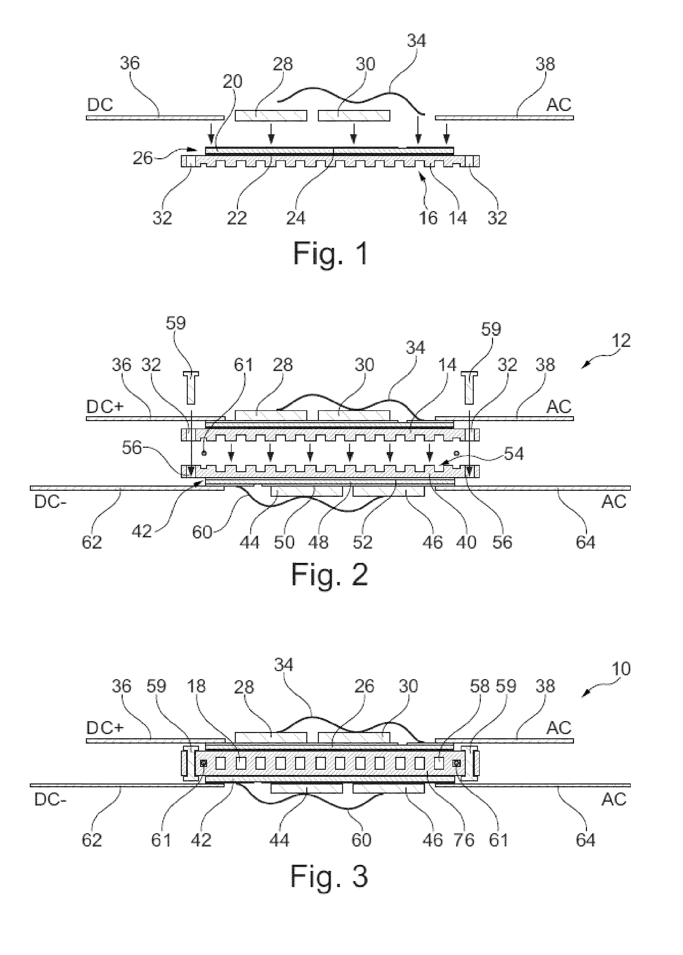

In figure 1, different parts for forming the power semiconductor module 10 and a semi-finished product 12 are shown. In detail, a first cooler part 14 is shown, which comprises a first part 16 of a cooling structure 18. On top of the cooler part 14, a layer 20 formed from an insulating material is provided which layer 20 is fixed to the first cooler part 14 by a metallic layer 22. A further metallic layer 24 such as a metallization is provided on top of the electrically insulating layer 20. The electrically insulating layer 20 together with the metallic layers 22, 24 form a first substrate 26 for supporting two power semiconductor devices 28, 30. In particular, a diode may be provided as a first power semiconductor device 28 and a switch may be provided as a second power semiconductor device 30.

The first cooler part 14 further comprises holes 32 which may be used for attaching said cooler part 14 to a further cooler part as will be described in detail down below.

As further parts, a wire bond 34 is shown which may be used for electrically connecting the power semiconductor devices 28, 30 and terminals 36, 38, which may be used as DC+ terminal and as AC terminal, respectively.

In figure 2, a semi-finished product 12 is shown which may be produced and used for forming the power semiconductor module 10. The semi-finished product 12 may be formed from twice the components shown in figure 1

Thus, the semi-finished product according to claim 1 comprises the first cooler part 14 having the first substrate 26 for supporting at least one power semiconductor device 28, 30 and comprising a second cooler part 40 having a second substrate 42 for supporting at least one power semiconductor device 44, 46. Again, a diode is used as the first power semiconductor device 44 and a switch is used as the second power semiconductor device, each power semiconductor devices 28, 30, 44, 46 being attached to the first substrate 26 and the second substrate 42, respectively. It can further be seen, that the first cooler part 14 is not assembled to the second cooler part 40.

Further, again, an electrically insulating layer 48 together with metallic layers 50, 52 formed under and above the insulating layer 48 form the second substrate 42. This may be advantageous in case the first and the second cooler parts 14, 40 are formed from an electrically conductive material, such as from a metal.

Further, it can be seen that the second cooler part comprises a second part 54 of a cooling structure 18 and holes 56 for introducing a screw 59.

As further parts, again, a wire bond 60 is shown which may be used for electrically connecting the power semiconductor devices 44, 46 and terminals 62, 64, which may be used as DC+ terminal and as AC terminal, respectively.

The first part 16 and the second part 54 of the cooling structure18 are designed such, that by assembling the first cooler part 14 to the second cooler part 40, at least one channel 58 of the cooling structure 18 is formed.

This is shown in figure 3, where the semi-finished 12 product is assembled to a power semiconductor module 10, wherein a cooler 76 is formed out of the first cooler part 14 and the second cooler part 40. The channels 58 for guiding a cooling liquid are shown, wherein the channels 58 may be sealed against the outside by a sealing 61. Further, the cooler parts 14, 40 are connected to each other by means of screws 59.

Thus, a method for producing a power semiconductor module 10, in particular for forming a half-bridge module, may in an embodiment comprise the steps of:
a) providing a first cooler part 14 having a first substrate 26 for supporting at least one power semiconductor device 28, 30;
b) providing a second cooler part 40 having a second substrate 42 for supporting at least one power semiconductor device 44, 46;
c) attaching at least one power semiconductor device 28, 30 to the first substrate 26;
d) attaching at least one power semiconductor device 44, 46 to the second substrate 42; and e) attaching the first cooler part 14 to the second cooler part 40 after each of steps c) and d).

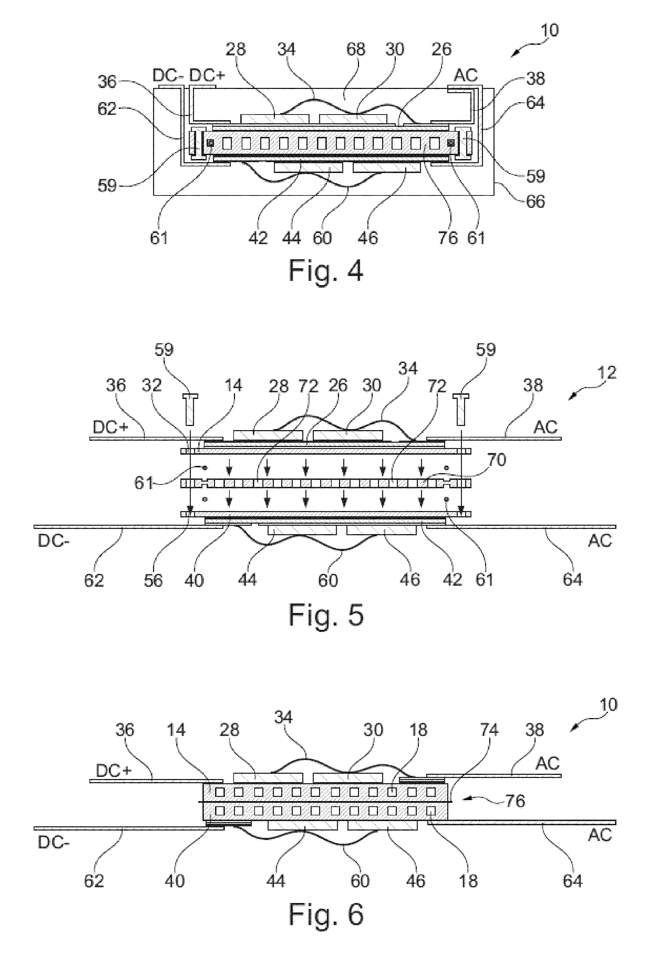

In order to complete the manufacturing step of the power semiconductor module 10, the method may optionally comprise the further step of encapsulating the power semiconductor module 10 in a housing 66, wherein the housing 66 is filled with an encapsulation material 68. This is shown in figure 4 in which a housing 66 is shown which is filled with an encapsulation material 68.

Figure 5 shows a further embodiment of a semi-finished product 12. According to figure 5, a third cooler part 70 is provided for positioning the third cooler part 70 between the first cooler part 14 and the second cooler part 40. It is further shown that the third cooler part 70 comprises at least a part 72 of a cooling structure 18. The cooling structure 18 is formed such, that by attaching the first cooler part 14 and the second cooler part 40 to the third cooler part 70, the cooling structure 18 is closed and channels 58 for carrying cooling liquid are formed. Again, a sealing 61 may be comprised in order to seal the channels 58 to the outside.

Figure 6 shows a further embodiment of a power semiconductor module 10. Such a module 10 may be formed from a semi-finished product 12, which comprises two cooler parts 14, 40, each of which comprise a cooling structure 18. Both cooling structures 18 are embedded in the respective cooler part 14, 40 and therefore provide independent cooling structures.

This embodiment may further be realized in that the first cooler part 14 and the second cooler part 40 are formed from an electrically conductive material. Due to the fact that both cooler parts 14, 40 are electrically conductive, an electrical insulator 74 is positioned between the first cooler part 14 and the second cooler part 40.

This allows the top and bottom coolers to be on different potentials, such that the semiconductor chips 28, 30, 44, 46 can be directly connected to the cooler parts 14, 40 for even better cooling performance.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### Reference signs list

- 10: power semiconductor module
- 12: semi-finished product
- 14: first cooler part
- 16: first part
- 18: cooling structure
- 20: layer
- 22: metallic layer
- 24: metallic layer
- 26: first substrate
- 28: power semiconductor device
- 30: power semiconductor device
- 32: hole
- 34: wire bond
- 36: terminal
- 38: terminal
- 40: second cooler part
- 42: second substrate
- 44: power semiconductor device
- 46: power semiconductor device
- 48: layer
- 50: metallic layer
- 52: metallic layer
- 54: second part
- 56: hole
- 58: channel
- 59: screw
- 60: wire bond
- 61: sealing
- 62: terminal
- 64: terminal
- 66: housing
- 68: encapsulation material
- 70: third cooler part
- 72: third part
- 74: electrical insulator
- 76: cooler

## Claims

1. Semi-finished product for producing a power semiconductor module (10), in particular for forming a half-bridge module, the semi-finished product (12) comprising a first cooler part (14) supporting at least one power semiconductor device (28, 30) and comprising a second cooler part (40) supporting at least one power semiconductor device (44, 46), wherein the first cooler part (14) is not assembled to the second cooler part (40).

2. Semi-finished product according to claim 1, **characterized in that** at least one diode and at least one switch are attached to the first cooler part (14) and wherein at least one diode and at least one switch are attached the second cooler part (40).

3. Semi-finished product according to any of claims 1 or 2, **characterized in that** the first cooler part (14) and the second cooler part (40) are formed from an electrically conductive material, such as from a metal.

4. Semi-finished product according to claim 3, **characterized in that** the first cooler part (14) comprises a first substrate (26), wherein the first substrate (26) comprises a substrate metallization (24) being formed on an electrically insulating layer (20), the electrically insulating layer (20) being located on the first cooler part (14) and/or **in that** the second cooler part (40) comprises a second substrate (42), wherein the second substrate (42) comprises a substrate metallization (50) being formed on an electrically insulating layer (48), the electrically insulating layer (48) being located on the second cooler part (40).

5. Semi-finished product according to any of claims 1 or 2, **characterized in that** the first cooler part (14) and the second cooler part (40) are formed from an electrically insulating material, such as a ceramic material.

6. Semi-finished product according to claim 5, **characterized in that** a substrate metallization is formed on the first cooler (14) part and/or **in that** a substrate metallization is formed on the second cooler part (40).

7. Semi-finished product according to any of the preceding claims, **characterized in that** a third cooler part (70) is provided for positioning the third cooler part (70) between the first cooler part (14) and the second cooler part (40).

8. Semi-finished product according to claim 7, **characterized in that** the third cooler part (70) is formed from an electrically insulating material.

9. Semi-finished product according to any of the preceding claims, **characterized in that** at least one of the first cooler part (14) and the second cooler part (40) and the third cooler part (70) comprise at least a part of a cooling structure (18).

10. Semi-finished product according to claim 9, **characterized in that** the first cooler part (14) comprises a first part (16) of the cooling structure (18) and the second cooler part (40) comprises a second part (54) of a cooling structure (18), wherein the first part (16) and the second part (54) of the cooling structure (18) are designed such, that by assembling the first cooler part (14) to the second cooler part (40), at least one channel (58) of the cooling structure (18) is formed.

11. Semi-finished product according to claim 9, **characterized in that** the third cooler part (70) comprises a cooling structure (18), wherein the cooling structure (18) is embedded in the third cooler part (70), or **in that** the third cooler part (70) comprises a part (72) of the cooling structure (18) and the first cooler part (14) and the second cooler part (40) and the third cooler part (70) are designed such, that by assembling the first cooler part (14) and the second cooler part (40) and the third cooler part (70), the cooling structure (18) is formed.

12. Method for producing a power semiconductor module (10), in particular for forming a half-bridge module, comprising the step of
a) providing a first cooler part (14) supporting at least one power semiconductor device (28, 30);
b) providing a second cooler part (40) supporting at least one power semiconductor device (44, 46);
c) attaching at least one power semiconductor device (28, 30) to the first cooler part (14);
d) attaching at least one power semiconductor device (44, 46) to the second cooler part (14);
e) assembling the first cooler part (14) and the second cooler part (40) after steps c) and d).

13. Method according to claim 12, **characterized in that** the first cooler part (14) and the second cooler part (40) are assembled by means of welding, by means of screws, by means of an adhesive, by means of a soldering step, or by means of a clamping step.

14. Method according to claim 12 or 13, **characterized in that** an electrical insulator (74) is positioned between the first cooler part (14) and the second cooler part (40).

15. Power semiconductor module comprising a cooler (76), **characterized in that** the cooler (76) comprises at least a first cooler part (14) and a second cooler part (40), wherein the first cooler part (14) and a second cooler part (40) are mechanically assembled to each other, and wherein the first cooler part (14) supports at least one power semiconductor device (28, 30) and wherein the second cooler part (40) supports at least one power semiconductor device (44, 46).
